(19) **Europäisches Patentamt**

**European Patent Office**

**Office européen des brevets**

(11) Veröffentlichungsnummer: **0 212 384 B1**

(12) **EUROPÄISCHE PATENTSCHRIFT**

(45) Veröffentlichungstag der Patentschrift: **30.09.92**

(21) Anmeldenummer: **86110608.6**

(22) Anmeldetag: **31.07.86**

(51) Int. Cl.⁵: **H03K 17/945**

(51) Int. Cl.⁵: **H03K 17/945**

(54) **Elektronisches, vorzugsweise berührungslos arbeitendes Schaltgerät.**

(30) Priorität: **21.08.85 DE 3529827**

(43) Veröffentlichungstag der Anmeldung:
**04.03.87 Patentblatt 87/10**

(45) Bekanntmachung des Hinweises auf die
Patenterteilung:
**30.09.92 Patentblatt 92/40**

(84) Benannte Vertragsstaaten:
**CH DE FR GB IT LI SE**

(56) Entgegenhaltungen:
**DE-A- 1 809 570**
**GB-A- 2 028 047**
**GB-A- 2 075 297**

**PATENT ABSTRACTS OF JAPAN, Band 7, Nr. 36 (E-158)[1181], 15. Februar 1983 & JP-A-57 188 134**

**PATENT ABSTRACTS OF JAPAN, Band 9, Nr. 89 (E-309)[1812], 18. April 1985 & JP-A-59 219 019**

(73) Patentinhaber: **i f m electronic gmbh**
**Teichstrasse 4**
**W-4300 Essen 1(DE)**

(72) Erfinder: **Lamarche, Jean-Luc, Dipl.-Ing.**
**Zeppelinstrasse 1**
**W-7994 Langenargen(DE)**

(74) Vertreter: **Gesthuysen, Hans Dieter, Dipl.-Ing. et al**
**Patentanwälte Gesthuysen + von Rohr**
**Huyssenallee 15 Postfach 10 13 33**
**W-4300 Essen 1(DE)**

Rank Xerox (UK) Business Services

EP 0 212 384 B1

## Beschreibung

Die Erfindung betrifft ein elektronisches, vorzugsweise berührungslos arbeitendes Schaltgerät mit den Merkmalen des Oberbegriffes des Patentanspruches 1.

Elektronische Schaltgeräte der zuvor beschriebenen Art sind kontaktlos ausgeführt und werden in zunehmendem Maße anstelle von elektrischen, mechanisch betätigten Schaltgeräten, die kontaktbehaftet ausgeführt sind, in elektrischen Meß-, Steuer- und Regelkreisen verwendet. Das gilt insbesonder für sogenannte Annäherungsschalter, d. h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weit genähert hat. Hat sich nämlich ein Beeinflussungselement, für das der entsprechende Annäherungsschalter sensitiv ist, dem Anwesenheitsindikator hinreichend weit genähert, so steuert der Anwesenheitsindikator den elektronischen Schalter um, d. h. bei einem als Schließer ausgeführten Schaltgerät wird der nichtleitende elektronische Schalter nunmehr leitend, während bei einem als Öffner ausgeführten Schaltgerät der leitende elektronische Schalter nunmehr sperrt. (Mit Schaltgeräten der in Rede stehenden Art kann auch indiziert werden, ob eine physikalische Größe eines Beeinflussungsmediums, für die das Schaltgerät sensitiv ist, einen entsprechenden Wert erreicht hat.)
Wesentlicher Bestandteil von elektronischen Schaltgeräten der zuvor beschriebenen Art ist also u. a. der von außen beeinflußbare Anwesenheitsindikator. Als Anwesenheitsindikator kann z. B. ein induktiv oder kapazitiv beeinflußbarer Oszillator vorgesehen sein; es handelt sich dann um induktive oder kapazitive Annäherungsschalter (vgl. z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877 und 27 44 785). Als Anwesenheitsindikator kann auch ein Fotowiderstand, eine Fotodiode oder ein Fototransistor vorgesehen sein; es handelt sich dann um optoelektronische Annäherungsschalter (vgl. z. B. die deutsche Offenlegungsschrift 28 24 582).

Bei induktiven Annäherungsschaltern gilt für den Oszillator, solange ein Metallteil einen vorgegebenen Abstand noch nicht erreicht hat, $K \cdot V = 1$ mit K = Rückkopplungsfaktor und V = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors V, so daß $K \cdot V < 1$ wird, d. h. der Oszillator hört auf zu schwingen. Bei kapazitiven Annäherungsschaltern gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, $K \cdot V < 1$, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors K, so daß $K \cdot V = 1$ wird, d. h. der Oszillator beginnt zu schwingen. Bei beiden Ausführungsformen wird abhängig von den unterschiedlichen Zuständen des Oszillators der elektronische Schalter, z. B. ein Transistor, ein Thyristor oder ein Triac, gesteuert.

Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Elektronische, berührungslos arbeitende Schaltgeräte sind anfangs mit einer Reihe von Problemen behaftet gewesen, - gemessen an elektrischen, mechanisch betätigten Schaltgeräten -, nämlich u. a. mit den Problemen "Erzeugung einer Speisespannung für den Oszillator", "Ausbildung des Oszillators", "Einschaltimpulsverhinderung". Mit diesen Problemen und deren Lösungen (und mit anderen, bei elektronischen, berührungslos arbeitenden Schaltgeräten relevanten Problemen und deren Lösungen) befassen sich z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 102, 30 38 141 und 30 38 692.

Im übrigen tritt bei elektronischen Schaltgeräten ein Problem auf, das bei elektrischen, also kontaktbehafteten Schaltgeräten weitgehend gelöst ist, nämlich das Problem des Überlastungs- und Kurzschlußschutzes. Das Problem des Überlastungs- und Kurzschlußschutzes ist bei elektrischen, kontaktbehafteten Schaltgeräten in einfacher Weise dadurch gelöst, daß entweder diesen Schaltgeräten Sicherungen vorgeschaltet sind, die bei einer Überlastung bzw. bei einem Kurzschluß ansprechen, oder daß diese Schaltgeräte selbst mit z. B. elektromagnetischen Überlastungs- und Kurzschlußauslösern ausgerüstet sind.

Das zuvor angesprochene Problem des Überlastungs- und Kurzschlußschutzes tritt auch dann auf, wenn es sich nicht um ein elektronisches Schaltgerät, sondern um einen elektronischen, analog arbeitenden Meßwertumformer handelt. Ein solcher Meßwertumformer kann z. B. ausgangsseitig einen Transistor haben, der nicht nur die dualen Zustände "durchgeschaltet" und "gesperrt" darstellen kann, sondern vielmehr eine der von dem Anwesenheitsindikator aufgenommenen Information analoge Ausgangsgröße realisiert.

Elektronische Schaltgeräte der eingangs beschriebenen Art, also solche, die einen Überlastungs- und Kurzschlußschutz haben, gehören ebenfalls bereits zum Stand der Technik (vgl. die deutschen Offenlegungsschriften 21 49 063, 23 31 732 und 25 15 654 sowie die deutsche Patentschrift 33 02 864).

Im Stand der Technik, von dem die Erfindung ausgeht (vgl. die japanische Offenlegungsschrift 57-188.134), ist der Auslösetransistor auch dann durchgesteuert, wenn der Ausgangstransistor nicht angesteuert ist. Folglich ist die Ansteuerung des Ausgangstransistors durch den Anwesenheitsindikator problematisch.

Der Erfindung liegt folglich die Aufgabe zugrunde, das bekannte elektronische Schaltgerät, von dem die Erfindung ausgeht, hinsichtlich der Ansteuerung des Auslösetransistors zu verbessern.

Das erfindungsgemäße elektronische Schaltgerät, bei dem die zuvor hergeleitete und dargelegte Aufgabe gelöst ist, ist dadurch gekennzeichnet, daß die Basis des Auslösetransistors einerseits über einen Ansteuerwiderstand mit dem Ausgang des Ansteuertransistors und andererseits mit dem Kollektor des Ausgangstransistors verbunden ist, - so daß der Auslösetransistor dann und nur dann leitend ist, wenn der Ansteuertransistor leitend ist und die Kollektorspannung des Ausgangstransistors durch Entsättigung um ein vorgegebenes Maß angestiegen ist. Während also bei dem elektronischen Schaltgerät, von dem die Erfindung ausgeht, der Auslösetransistor dann durchgesteuert ist, wenn am Kollektor des Ausgangstransistors ein hinreichend großes Potential ansteht, gilt für das erfindungsgemäße elektronische Schaltgerät, daß der Auslösetransistor dann und nur dann durchgesteuert ist, wenn einerseits der Ansteuertransistor durchgesteuert ist und andererseits am Kollektor des Ausgangstransistors ein hinreichend hohes Potential ansteht.

Im folgenden werden die Lehre der Erfindung sowie Ausgestaltungen und Weiterbildungen der Lehre der Erfindung anhand eines zeichnerisch dargestellten Ausführungsbeispiels näher erläutert; es zeigt

Fig. 1   ein Schaltbild eines erfindungsgemäßen elektronischen, hier berührungslos arbeitenden Schaltgerätes und

Fig. 2   einen vergrößerten Ausschnitt aus dem Schaltbild des elektronischen Schaltgerätes nach Fig. 1.

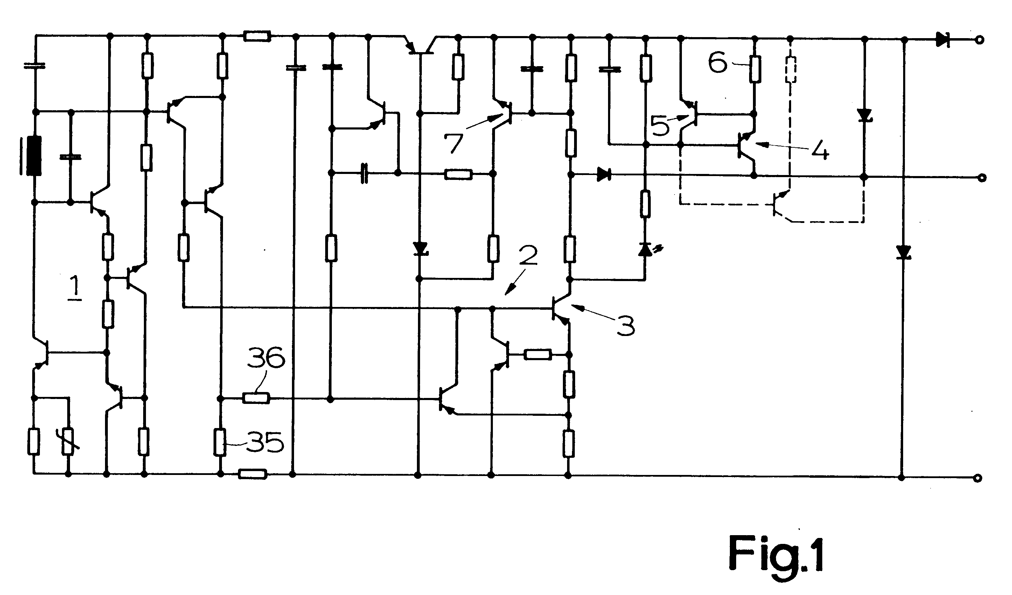

Zu dem in Fig. 1 dargestellten elektronischen, berührungslos arbeitenden Schaltgerät gehören ein von außen beeinflußbarer Anwesenheitsindikator, hier ein Oszillator 1, ein von dem Oszillator 1 über einen Schaltverstärker 2 mit einem Ansteuertransistor 3 steuerbarer Ausgangstransistor 4 und ein Überlstungs- und Kurzschlußschutz. Dabei ist der Basis-Emitter-Strecke des Ausgangstransistors 4 die Kollektor-Emitter-Streckeeines Ableittransistors 5 parallelgeschaltet, liegt im Emitterkreis des Ausgangstransistors 4 ein Emitterwiderstand 6 und ist ein Auslösetransistor 7 vorgesehen.

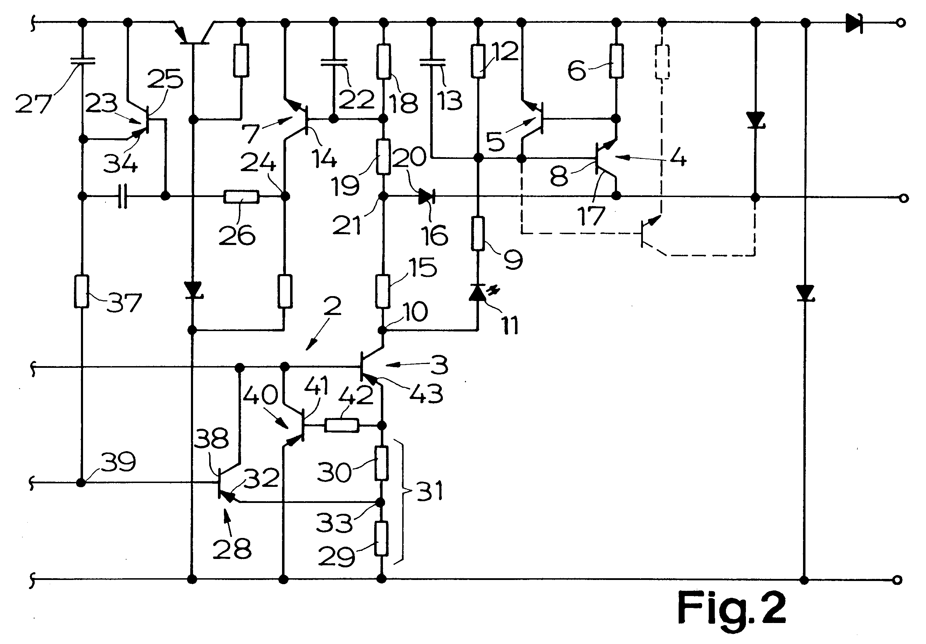

Der Oszillator 1 des erfindungsgemäßen elektronischen Schaltgerätes bedarf der besonderen Erläuterung nicht. Das ist auch der Grund dafür, warum der Oszillator 1 in dem Ausschnitt des Schaltbildes des elektronischen Schaltgerätes, das Fig. 2 zeigt, nicht dargestellt ist.

Erfindungsgemäß wird der Auslösetransistor 7 in Abhängigkeit von der Kollektorspannung des Ausgangstransistors 4 angesteuert.

Bei dem in den Figuren dargestellten Ausführungsbeispiel eines erfindungsgemäßen elektronischen Schaltgerätes ist die Basis 8 des Ausgangstransistors 4 über einen Ansteuerwiderstand 9 mit dem Ausgang 10 des Ansteuertransistors 3 verbunden, und zwar unter Zwischenschaltung einer Leuchtdiode 11; der Ausgang 10 des Ansteuertransistors 3 ist hier dessen Kollektor. Der Reihenschaltung der Basis-Emitter-Strecke des Ausgangstransistors 4 und des Emitterwiderstandes 6 ist ein Spannungsteilerwiderstand 12 parallelgeschaltet; der Ansteuerwiderstand 9 und der Spannungsteilerwiderstand 12 bilden einen Spannungsteiler. Dann, wenn der Ansteuertransistor 3 durchgesteuert ist, wird über den Ansteuertransistor 3, die Leuchtdiode 11, den Ansteuerwiderstand 9 und den Spannungsteilerwiderstand 12 der Ausgangstransistor 4 durchgesteuert.

Im dargestellten Ausführungsbeispiel ist der Kollektor-Emitter-Strecke des Ableittransistors 5 ein Glättungskondensator 13 parallelgeschaltet. Der Glättungskondensator 13 wirkt Schwingungen entgegen, die durch den Ableittransistor 5 entstehen können, wenn dessen Verstärkung relativ groß ist.

Die wesentliche Lehre der Erfindung, den Auslösetransistor 7 in Abhängigkeit von der Kollektorspannung des Ausgangstransistors 4 anzusteuern, ist im dargestellten Ausführungsbeispiel nun konkret dadurch realisiert, daß die Basis 14 des Auslösetransistors 7 einerseits über einen Ansteuerwiderstand 15 mit dem Ausgang 10 des Ansteuertransistors 3 und andererseits über eine Koppeldiode 16 mit dem Kollektor 17 des Ausgangstransistors 4 verbunden ist. Dabei ist der Basis-Emitter-Strecke des Auslösetransistors 7 ein Spannungsteilerwiderstand 18 parallelgeschaltet, zwischen dem Ansteuerwiderstand 15 und dem Spannungsteilerwiderstand 18 ein weiterer Spannungsteilerwiderstand 19 vorgesehen, die Anode 20 der Koppeldiode 16 an den Verbindungspunkt 21 des Ansteuerwiderstandes 15 und des weiteren Spannungsteilerwiderstandes 19 angeschlossen und der Basis-Emitter-Strecke des Auslösetransistors 7 ein Auslöseverzögerungskondensator 22 parallelgeschaltet. In dem in den Figuren dargestellten Ausführungsbeispiel eines erfindungsgemäßen elektronischen Schaltgerätes ist weiter ein Hilfstransistor 23 vorgesehen, der vom Ausgang 24 des Auslösetransistors 7 angesteuert ist; der Ausgang 24 des Auslösetransistors 7 ist hier dessen Kollektor. Im einzelnen ist die Basis 25 des Hilfstransistors 23 über einen Basiswiderstand 26 an den Ausgang 24 des Auslösetransistors 7 angeschlossen und ist der Emitter-Strecke des Hilfstransistors 23 ein Einschaltverzögerungskondensator 27 parallelgeschaltet.

Auch insoweit zeigen die Figuren eine bevorzugte Ausführungsform des erfindungsgemäßen elektronischen Schaltgerätes, als dem Ansteuertransistor 3 ein Eingangstransistor 28 zugeordnet ist und der Eingangstransistor 28 und der Ansteuertransistor 3 zusammen einen Schmitt-Trigger bilden, im Emitterkreis des Ansteuertransistors 3 ein aus zwei Spannungsteilerwiderständen 29, 30 bestehender Emitterwiderstand 31 liegt, der Emitter 32 des Eingangstransistors 28 an den Verbindungspunkt 33 der beiden Spannungsteilerwiderstände 29, 30 angeschlossen ist, dem Emitter 34 des Hilfstransistors 23 ein aus drei Spannungsteilerwiderständen 35, 36, 37 bestehender Spannungsteiler vorgeschaltet und die Basis 38 des Eingangstransistors 28 an den Verbindungspunkt 39 der beiden Spannungsteilerwiderstände 36, 37 angeschlossen ist und der Reihenschaltung aus dem Emitterwiderstand 31 und der Emitter-Kollektor-Strecke des Ansteuertransistors 3 die Emitter-Kollektor-Strecke eines Regeltransistors 24 parallelgeschaltet und die Basis 41 des Regeltransistors 40 über einen Basiswiderstand 42 an den Emitter 43 des Ansteuertransistors 3 angeschlossen ist.

Zur Funktionsweise der Lehre der Erfindung und des dargestellten Ausführungsbeispiels folgendes:
Es sei angenommen, daß der Eingangstransistor 28 nicht leitend ist. Dann ist der Ansteuertransistor 3 leitend und über den Emitterwiderstand 31, die Emitter-Kollektor-Strecke des Ansteuertransistors 3, die Leuchtdiode 11, den Ansteuerwiderstand 9 und den Spannungsteilerwiderstand 12 fließt ein Strom, der zur Folge hat, daß der Ausgangstransistor 4 leitend ist; ein nicht dargestellter Verbraucher wird über den Ausgangstransistor 4 durchgeschaltet.

Liegt in bezug auf das in Rede stehende elektronische Schaltgerät weder eine Überlastung noch ein Kurzschluß vor, so ist der Spannungsabfall am Emitterwiderstand 6 so gering, daß der Ableittransistor 5 nicht leitend ist, und ist die Kollektorspannung des Ausgangstransistors 4 so gering, daß der Auslösetransistor 7 nicht leitend ist. Ist der Auslösetransistor 7 nicht leitend, so kann kein Strom durch die Emitter-Basis-Strecke des Hilfstransistors 23 fließen, so daß auch der Hilfstransistor 23 nicht leitend ist.

Tritt nun eine Überlastung des dargestellten elektronischen Schaltgerätes oder ein Kurzschluß an diesem Schaltgerät auf, so passieren zwei Dinge gleichzeitig:
Einerseits wird nun der Ableittransistor 5 leitend, so daß der Ausgangstransistor 4 entsättigt wird. Andererseits steigt die Kollektorspannung des Ausgangstransistors 4 an.

Die am Ausgangstransistor 4 ansteigende Kollektorspannung führt dazu, daß das Potential am Verbindungspunkt 21 von Ansteuerwiderstand 15 und Spannungsteilerwiderstand 19 ansteigt; das Potential am Verbindungspunkt 21 von Ansteuerwiderstand 15 und Spannungsteilerwiderstand 19 liegt immer um den Spannungsabfall an der Koppeldiode 16 über dem Potential am Kollektor 17 des Ausgangstransistors 4. Dadurch, daß das Potential am Verbindungspunkt 21 von Ansteuerwiderstand 15 und Spannungsteilerwiderstand 19 ansteigt, steigt auch das Potential an der Basis 14 des Auslösetransistors 7 an, verzögert durch den Auslöseverzögerungskondensator 22. Nach der Auslöseverzögerungszeit wird der Auslösetransistor 7 leitend, was zur Folge hat, daß auch der Hilfstransistor 23 leitend wird. Durch den leitenden Hilfstransistor 23 wird der Eingangstransistor 28 leitend, so daß der Ansteuertransistor 3 sperrt. Der gesperrte Ansteuertransistor 3 hat zur Folge, daß auch der Ausgangstransistor 4, der Ableittransistor 5 und der Auslösetransistor 7 vom leitenden Zustand in den gesperrten Zustand übergehen. Nach einer durch den Einschaltverzögerungskondensator 27 vorgegebenen Einschaltverzögerungszeit sperrt dann der Hilfstransistor 23, so daß danach wieder der Eingangstransistor 28 sperrt, der Ansteuertransistor 23 leitend wird usw..

Im dargestellten Ausführungsbeispiel wird also der Ausgangstransistor 4 immer wieder angesteuert, und zwar solange, bis eine Überlastung bzw. ein Kurzschluß nicht mehr vorliegt und der leitende Ausgangstransistor 4 leitend bleibt.

Der im dargestellten Ausführungsbeispiel vorhandene Regeltransistor 40 sorgt für einen konstanten Strom über die Emitter-Kollektor-Strecke des Ansteuertransistors 3 und damit auch für einen konstanten Strom über die Leuchtdiode 11. Zur Funktionsweise des Regeltransistors 40 wird auf die DE-A-33 26 440 verwiesen, deren Offenbarungsgehalt hiermit ausdrücklich auch zum Offenbarungsgehalt dieser Patentanmeldung gemacht wird.

## Patentansprüche

1. Elektronisches, vorzugsweise berührungslos arbeitendes Schaltgerät, mit einem von außen beeinflußbaren Anwesenheitsindikator, z. B. einem Oszillator (1), mit einem einen Ansteuertransistor (3) aufweisenden Schaltverstärker (2), mit einem von dem Anwesenheitsindikator über den Schaltverstärkker (2) steuerbaren Ausgangstransistor (4), mit einem den Ausgangstransistor (4) bei Überlastung entsättigenden Ableittransistor (5) oder einer Ableitzenerdiode und mit einem Auslösetransistor (7), wobei im Emitterkreis des Ausgangstransistors (4) ein Emitterwiderstand (6) liegt, die Kollektor-Emitter-Strecke des Ausgangstransistors (4) über den Emitterwiderstand (6) mit dem äußeren Lastkreis (Last- und Betriebsspannung) in Reihe liegt, der Reihenschaltung aus der Basis-Emitter-Strecke des Ausgangstransistors (4) und dem Emitterwiderstand (6) die Kollektor-Emitter-Strecke des Ableittransistors (5) oder die Ableitzenerdiode parallelgeschaltet ist und der Auslösetransistor (7) von der bei einer Entsättigung des Ausgangstransistors (4) ansteigenden Kollektorspannung des Ausgangstransistors (4) durchgesteuert wird, der durchgesteuerte Auslösetransistor (7) den Ansteuertransistor (3) sperrt und der gesperrte Ansteuertransistor (3) den Ausgangstransistor (4) sperrt, **dadurch gekennzeichnet,** daß die Basis (14) des Auslösetransistors (7) einerseits über einen Ansteuerwiderstand (15) mit dem Ausgang (10) des Ansteuertransistors (3) und andererseits mit dem Kollektor (17) des Ausgangstransistors (4) verbunden ist, - so daß der Auslösetransistor (7) dann und nur dann leitend ist, wenn der Ansteuertransistor (3) leitend ist und die Kollektorspannung des Ausgangstransistors (4) durch Entsättigung um ein vorgegebenes Maß gestiegen ist.

2. Elektronisches Schaltgerät nach Anspruch 1, dadurch gekennzeichnet, daß die Basis (8) des Ausgangstransistors (4) über einen Ansteuerwiderstand (9) mit den Ausgang (10) des Ansteuertransistors (3) verbunden ist.

3. Elektronisches Schaltgerät nach Anspruch 2, dadurch gekennzeichnet, daß der Reihenschaltung der Basis-Emitter-Strecke des Ausgangstransistors (4) und des Emitterwiderstandes (6) ein Spannungsteilerwiderstand (12) parallelgeschaltet ist.

4. Elektronisches Schaltgerät nach einem der Ansprüche 1 bis 3, dadurch gekennzeichnet, daß der Kollektor-Emitterstrecke des Ableittransistors (5) ein Glättungskondensator (13) parallelgeschaltet ist.

5. Elektronisches Schaltgerät nach einem der Ansprüche 1 bis 4, dadurch gekennzeichnet, daß die Basis (14) des Auslösetransistors (7) über eine Koppeldiode (16) mit dem Kollektor (17) des Ausgangstransistors (4) verbunden ist.

6. Elektronisches Schaltgerät nach Anspruch 5, dadurch gekennzeichnet, daß der Basis-Emitterstrecke des Auslösetransistors (7) ein Spannungsteilerwiderstand (18) parallelgeschaltet ist.

7. Elektronisches Schaltgerät nach Anspruch 6, dadurch gekennzeichnet, daß zwischen dem Ansteuerwiderstand (15) und dem Spannungsteilerwiderstand (18) ein weiterer Spannungsteilerwiderstand (19) vorgesehen ist und die Anode (20) der Koppeldiode (16) an den Verbindungspunkt (21) des Ansteuerwiderstandes (15) und des weiteren Spannungsteilerwiderstandes (19) angeschlossen ist.

8. Elektronisches Schaltgerät nach einem der Ansprüche 1 bis 7, dadurch gekennzeichnet, daß der Basis-Emitterstrecke des Auslösetransistors (7) ein Auslöseverzögerungskondensator (22) parallelgeschaltet ist.

9. Elektronisches Schaltgerät nach einem der Ansprüche 1 bis 8, dadurch gekennzeichnet, daß ein Hilfstransistor (23) vorgesehen ist und der Hilfstransistor (23) vom Ausgang (24) des Auslösetransistors (7) angesteuert ist.

10. Elektronisches Schaltgerät nach Anspruch 9, dadurch gekennzeichnet, daß die Basis (25) des Hilfstransistors (23) über einen Basiswiderstand (26) an den Ausgang (23) des Auslösetransistors (7) angeschlossen ist.

11. Elektronisches Schaltgerät nach Anspruch 9 oder 10, dadurch gekennzeichnet, daß der Emitter-Kollektorstrecke des Hilfstransistors (23) ein Einschaltverzögerungskondensator (27) parallelgeschaltet ist.

12. Elektronisches Schaltgerät nach einem der Ansprüche 1 bis 11, dadurch gekennzeichnet, daß dem Ansteuertransistor (3) ein Eingangstransistor (28) zugeordnet ist und der Eingangstransistor (28) und der Ansteuertransistor (3) zusammen einen Schmitt-Trigger bilden.

## Claims

1. Electronic switchgear, preferably working contactless, comprising: a presence indicator that can be influenced externally, for example an oscillator (1), a switch amplifier (2) including a trigger transistor (3), an output transistor (4) controllable by said presence indicator via said switching amplifier (2), a shunt transistor (5) or a shunt Zener diode desaturating said output transistor (4) by overload, and a trip transistor (7), wherein an emitter-resistor (6) is located in the emitter circuit of said output transistor (4), the collector-emitter path of said output transistor (4) is connected in series via said emitter resistor (6) with the outer charging circuit (charging voltage and operating voltage), the collector-emitter path of said shunt transistor (5) or said shunt Zener diode is connected parallel to the series connection of the base-emitter path of said output transistor (4) and said emitter resistor (6), said trip transistor (7) is triggered as a function of the collector voltage of said output transistor (4), which increases with desaturation of said output transistor (4), and said triggered trip transistor (7) blocks said trigger transistor (3) and said blocked trigger transistor (3) blocks said output transistor (4), **characterized in that** the base (14) of said trip transistor (7) in conneted on the one hand to the output (10) of said trigger transistor (3) via a trigger resistor (15) and is connected on the other hand to the collector (17) of said output transistor (4), - so that said trip transistor (7) then and only then is conductive, when said trigger transistor (3) is conductive and said collector voltage of said output transistor (4) is increased by desaturation by a predetermined amount.

2. Electronic switchgear according to claim 1, wherein the base (8) of said output transistor (4) is connected via a trigger resistor (9) to said output (10) of said trigger transistor (3).

3. Electronic switchgear according to claim 2, wherein a voltage divider resistor (12) is connected parallel to said series connection of said base-emitter path of said output transistor (4) and said emitter resistor (6).

4. Electronic switchgear according to one of the claims 1 to 3, wherein a filter capacitor (13) is connected parallel to said collector-emitter path of said shunt transistor (5).

5. Electronic switchgear according to one of the claims 1 to 4, wherein said base (14) of said trip transistor (7) is connected via a coupling diode (16) to the collector (17) of said output transistor (4).

6. Electronic switchgear according to claim 5, wherein a voltage divider resistor (18) is connected parallel to the base-emitter path of said trip transistor (7).

7. Electronic switchgear according to claim 6, wherein a further voltage divider resistor (19) is provided between said trigger resistor (15) and said voltage devider resistor (18) and the anode (20) of said coupling diode (16) is connected to the junction (21) of said trigger resistor (15) and of said further voltage divider resistor (19).

8. Electronic switchgear according to one of the claims 1 to 7, wherein a trip delay capacitor (22) is connected parallel to said base-emitter path of said trip transistor (7).

9. Electronic switchgear according to one of the claims 1 to 8, wherein an auxiliary transistor (23) is provided and said auxiliary transistor (23) is triggered by the output (24) of said trip transistor (7).

10. Electronic switchgear according to claim 9, wherein the base (25) of said auxiliary transistor (23) is connected via a base resistor (26) to the output (24) of said trip transistor (7).

11. Electronic switchgear according to claim 9 or 10, wherein a rise delay capacitor (27) is connected parallel to the emitter-collector path of said auxiliary transistor (23).

12. Electronic switchgear according to one of the claims 1 to 11, wherein an input transistor (28) is associated to said trigger transistor (3), and said input transistor (28) and said trigger transistor (3) together form a Schmitt-Trigger.

## Revendications

1. Appareil de distribution électronique travaillant, de préférence, sans contact, comprenant un indicateur de présence influençable de l'extérieur, par exemple un oscillateur (1), un amplificateur de commutation (2) présentant un transistor d'amorçage (3), un transistor de sortie (4) qui peut être commandé à partir de l'indicateur de présence par l'intermédiaire de l'amplificateur de commutation (2), un transistor de déviation (5) ou une diode Zener de déviation désaturant le transistor de sortie (4) lors d'une surcharge, ainsi qu'un transistor de déclenchement (7), dans lequel une résistance d'émetteur (6) est disposée dans le circuit d'émetteur du transistor de sortie (4), le tronçon collecteur-émetteur du transistor de sortie (4) est monté en série avec le circuit de charge externe (tension de charge et de fonctionnement) par l'intermédiaire de la résistance d'émetteur (6), le tronçon collecteur-émetteur du transistor de dérivation (5) ou la diode Zener de dérivation est monté en parallèle avec le montage en série constitué par le tronçon base-émetteur du transistor de sortie (4) et par la résistance d'émetteur (6), et le transistor de déclenchement (7) est traversé par la commande émanant de la tension du collecteur du transistor de sortie (4), qui s'élève lors d'une désaturation du transistor de sortie (4), le transistor de déclenchement (7) traversé par la commande coupe le transistor d'amorçage (3) et le transistor d'amorçage (3) coupé coupe le transistor de sortie (4), **caractérisé en ce que** la base (14) du transistor de déclenchement (7) est reliée, d'une part à la sortie (10) du transistor d'amorçage (3) par l'intermédiaire d'une résistance d'amorçage (15), et d'autre part au collecteur (17) du transistor de sortie (4), si bien que le transistor de déclenchement (7) est seulement et seulement alors conducteur, lorsque le transistor d'amorçage (3) est conducteur et lorsque la tension du collecteur du transistor de sortie (4) s'est élevée d'une valeur prédéfinie à cause d'une désaturation.

2. Appareil de distribution électronique selon la revendication 1, **caractérisé en ce que** la base (8) du transistor de sortie (4) est reliée à la sortie (10) du transistor d'amorçage (3) à l'intervention d'une résistance d'amorçage (9).

3. Appareil de distribution électronique selon la revendication 2, **caractérisé en ce qu'**une résistance de diviseur de tension (12) est montée en parallèle au montage en série du tronçon base-émetteur du transistor de sortie (4) et de la résistance d'émetteur (6).

4. Appareil de distribution électronique selon l'une quelconque des revendications 1 à 3, **caractérisé en ce qu'**un condensateur de filtrage (13) est monté en parallèle au tronçon collecteur-émetteur du transistor de dérivation (5).

5. Appareil de distribution électronique selon l'une quelconque des revendications 1 à 4, **caractérisé en ce que** la base (14) du transistor de déclenchement (7) est reliée au collecteur (17) du transistor de sortie (4) à l'intervention d'une diode de couplage (16).

6. Appareil de distribution électronique selon la revendication 5, **caractérisé en ce qu'**une résistance de diviseur de tension (18) est montée en parallèle au tronçon base-émetteur du transistor de déclenchement (7).

7. Appareil de distribution électronique selon la revendication 6, **caractérisé en ce qu'**on prévoit, entre la résistance d'amorçage (15) et la résistance de diviseur de tension (18), une autre résistance de diviseur de tension (19), l'anode (20) de la diode de couplage (16) étant raccordée au point de liaison (21) de la résistance d'amorçage (15) et de la résistance supplémentaire de diviseur de tension (19).

8. Appareil de distribution électronique selon l'une quelconque des revendications 1 à 7, **caractérisé en ce qu'**un condensateur de temporisation de déclenchement (22) est monté en parallèle au tronçon base-émetteur du transistor de déclenchement (7).

9. Appareil de distribution électronique selon l'une quelconque des revendications 1 à 8, **caractérisé en ce qu'**on prévoit un transistor auxiliaire (23), le transistor auxiliaire (23) étant amorcé depuis la sortie (24) du transistor de déclenchement (7).

10. Appareil de distribution électronique selon la revendication 9, **caractérisé en ce que** la base (25) du transistor auxiliaire (23) est raccordée à la sortie (23) du transistor de déclenchement (7) à l'intervention d'une résistance de base (26).

**11.** Appareil de distribution électronique selon l'une quelconque des revendications 9 ou 10, **caractérisé en ce qu'**un condensateur de temporisation de commutation (27) est monté en parallèle au tronçon émetteur-collecteur du transistor auxiliaire (23).

**12.** Appareil de distribution électronique selon l'une quelconque des revendications 1 à 11 **caractérisé en ce qu'**on attribue un transistor d'entrée (28) au transistor d'amorçage (3), le transistor d'entrée (28) et le transistor d'amorçage (3) formant conjointement une bascule de Schmitt.

Fig.1

EP 0 212 384 B1

Fig.2